# EUROPÄISCHE PATENTSCHRIFT

(11) **EP 1 483 063 B1**
(45) Veröffentlichungstag und Bekanntmachung des Hinweises auf die Patenterteilung: **04.10.2006**
(21) Anmeldenummer: 03718683.0
(22) Anmeldetag: 11.03.2003
(51) Int. Cl.: B08B 7/00

(54) **VERFAHREN UND VORRICHTUNG ZUR DEKONTAMINATION OPTISCHER OBERFLÄCHEN**
METHOD AND DEVICE FOR THE DECONTAMINATION OF OPTICAL SURFACES
PROCEDE ET DISPOSITIF DE DECONTAMINATION DE SURFACES OPTIQUES

(30) Priorität: 12.03.2002 DE 10211611
(43) Veröffentlichungstag der Anmeldung: 08.12.2004
(73) Patentinhaber: Carl Zeiss SMT AG, 73447 Oberkochen (DE)
(72) Erfinder: LÜDECKE, Jens, 73431 Aalen (DE); ZAZCEK, Christoph, 73540 Heubach (DE); PAZIDIS, Alexandra, 73431 Aalen (DE); ULLMANN, Jens, 73447 Oberkochen (DE); MÜHLPFORDT, Annette, 73431 Aalen (DE); THIER, Michael, 73563 Mögglingen (DE); WIESNER, Stefan, 73446 Lauchheim (DE)
(74) Vertreter: Patentanwälte Ruff, Wilhelm, Beier, Dauster & Partner
(86) Internationale Anmeldenummer: PCT/EP2003/002464
(87) Internationale Veröffentlichungsnummer: WO 2003/076086

(56) Entgegenhaltungen:
- WO-A-97/13646
- US-A- 4 028 080
- US-B1- 6 277 767
- PATENT ABSTRACTS OF JAPAN vol. 009, no. 188 (C-295), 3. August 1985 (1985-08-03) & JP 60 058238 A (USHIO DENKI KK), 4. April 1985 (1985-04-04)

## Beschreibung

Die Erfindung bezieht sich auf ein Verfahren und eine Vorrichtung zur Dekontamination von Oberflächen strahlführender Optiken unter Verwendung von UV-Strahlung in einer Reinigungsatmosphäre. Verfahren und Vorrichtungen dieser Art dienen beispielsweise zur Dekontamination von Oberflächen von Linsen und anderen optischen Elementen in strahlführenden Optiken, wie in Mikrolithographie-Projektionsbelichtungsanlagen.

Bei modernen Mikrolithographie-Projektionsbelichtungsanlagen, die mit sehr kurzwelliger Strahlung im tiefen Ultraviolettbereich (DUV) zwischen ca. 100nm und ca. 300nm und speziell z.B. mit 157nm Laserstrahlung arbeiten, machen sich Verunreinigungen an von der Belichtungsstrahlung getroffenen Oberflächen der strahlführenden Optik sehr störend durch Absorption und/oder Streuung bemerkbar. Der Dekontaminationsprozess dient dazu, solche Verunreinigungen zu beseitigen oder jedenfalls auf ein akzeptables Maß zu verringern.

Ein hierfür eingesetztes Dekontaminationsverfahren und eine zugehörige, in eine Mikrolithographie-Projektionsbelichtungsanlage integrierte Dekontaminationsvorrichtung sind in der Offenlegungsschrift DE 198 30 438 A1 beschrieben. Bei der dortigen Technik ist zusätzlich zu einem als Belichtungs-Lichtquelle dienenden DUV-Excimerlaser eine als Dekontaminations-Lichtquelle dienende, zweite UV-Lichtquelle vorgesehen, z.B. ein breitbandiger DUV-Excimerlaser oder eine 222nm UV-Excimerlampe. Die in die Projektionsbelichtungsanlage integrierte Dekontaminations-Lichtquelle wird in Belichtungspausen der Belichtungs-Lichtquelle aktiviert. Parallel dazu wird ein Reinigungsgasstrom auf die zu reinigenden Oberflächen gerichtet, wozu die Verwendung eines ozonhaltigen oder sauerstoffhaltigen Gasstroms vorgeschlagen wird. Unter letzterem ist ein Gasstrom mit höherem Sauerstoffgehalt als Luft zu verstehen, da dieser Vorgehensweise die Vorstellung zugrunde liegt, dass eine ausreichende Reinigungswirkung eine entsprechend hohe Sauerstoffkonzentration im Reinigungsgasstrom bedingt.

Dieser Reinigungseffekt durch eine Kombination von UV-Strahlung und sauerstoffreichem bzw. ozonhaltigem Gas ist auch für die Dekontamination von Substratoberflächen, wie Oberflächen von Glassubstraten und Wafern, bekannt, siehe beispielsweise Dokument US 6277767-B1 oder die Offenlegungsschrift JP 07-288109 A, in der die Kombination einer Xe-Excimerstrahlung z.B. einer Wellenlänge von 172nm in Kombination mit einer ozonhaltigen Reinigungsatmosphäre oder einer Luftatmosphäre vorgeschlagen wird. Der Sauerstoff wird zur Oxidation organischer Verunreinigungen und zur Bildung hydrophiler Gruppen in der entsprechenden Konzentration für notwendig erachtet. Der Tatsache, dass die Reichweite von UV-Reinigungsstrahlung im Wellenlängenbereich um 172nm wegen hoher Sauerstoffabsorption relativ gering ist, wird dadurch begegnet, dass die zu reinigende Oberfläche ausreichend nahe, z.B. weniger als 3mm, an die UV-Reinigungslichtquelle herangeführt wird oder UV-Reinigungsstrahlung höherer Wellenlänge von z.B. 185nm oder 254nm eingesetzt wird.

Eine Reinigung von Oberflächen strahlführender Optiken, die auf die Führung relativ kurzwelliger Laserstrahlung von z.B. 157nm ausgelegt sind, mit Laserstrahlung derselben Wellenlänge ist zwar möglich, jedoch in der Praxis sehr aufwendig und auf relativ kleine zu reinigende Flächen von wenigen Quadratmillimetern limitiert.

Der Erfindung liegt als technisches Problem die Bereitstellung eines Verfahrens und einer Vorrichtung der eingangs genannten Art zugrunde, mit denen sich Oberflächen strahlführender Optiken, insbesondere Optiken zur Strahlführung von DUV-Laserstrahlung im Wellenlängenbereich um 157nm und weniger, mit relativ geringem Aufwand auch über größere Oberflächengebiete hinweg zuverlässig von störenden Verunreinigungen dekontaminieren lassen.

Die Erfindung löst dieses Problem durch die Bereitstellung eines Verfahrens mit dem Merkmalen des Anspruchs 1 und einer Vorrichtung mit den Merkmalen des Anspruchs 4.

Erfindungsgemäß ist vorgesehen, zur Dekontamination eine UV-Strahlung mit einer Wellenlänge zu verwenden, die in einem Bereich starker Sauerstoffabsorption liegt, und der Problematik einer durch die hohe Absorption geringen Reichweite der Dekontaminationsstrahlung dadurch zu begegnen, dass als Reinigungsatmosphäre eine solche mit vergleichsweise geringer Sauerstoffkonzentration benutzt wird, die kleiner als diejenige von Luft ist. Untersuchungen haben gezeigt, dass durch die Kombination einer derartigen Dekontaminationsstrahlung mit einer sauerstoffarmen bzw. sauerstofffreien Reinigungsatmosphäre eine ausreichende Reinigungswirkung auch für strahlführende Optiken erzielbar ist, die auf die Führung von kurzwelligem UV-Laserlicht von z.B. 157nm ausgelegt sind, wie solche von mit DUV-Strahlung arbeitenden Mikrolithographie-Projektionsbelichtungsanlagen.

In einer vorteilhaften Weiterbildung der Erfindung nach Anspruch 2 bzw. 5 wird die Sauerstoffkonzentration der Reinigungsatmosphäre unter 1% gehalten, vorzugsweise unter 0,1%.

In einer vorteilhaften Ausgestaltung der Erfindung nach Anspruch 3 bzw. 6 wird die Dekontaminationsstrahlung von einer Xe-Entladungslampe mit einer Wellenlänge 172nm oder von einer Quecksilber-Niederdrucklampe erzeugt. In beiden Fällen ergibt sich im Vergleich zur Verwendung kurzwelliger Laserstrahlung im Wellenbereich um 157nm ein deutlich niedrigerer Aufwand bei ausreichender Reinigungswirkung.

Eine nach Anspruch 7 weitergebildete Dekontaminationsvorrichtung umfasst eine Reinigungskammer mit einem Reinigungsbereich, in welchem z.B. optische Elemente zwecks Reinigung ihrer Oberflächen platziert werden können. Zur Reinigung dienen mehrere im Abstand angeordnete UV-Strahler, die auf den Reinigungsbereich wirken, wobei über den Reinigungsbereich hinweg ein sauerstoffarmer bzw. sauerstofffreier Reinigungsgasstrom geführt werden kann.

In einer vorteilhaften Weiterbildung der Erfindung ist nach Anspruch 8 die Dekontaminationsvorrichtung in eine optische Baugruppe integriert, so dass die Oberflächen von deren optischen Elementen auch nach Inbetriebnahme der Baugruppe von Zeit zu Zeit gereinigt werden können. In einer vorteilhaften Ausgestaltung dieser Maßnahme ist die optische Baugruppe gemäß Anspruch 9 Teil einer Mikrolithographie-Projektionsbelichtungsanlage, so dass die Oberflächen von deren optischen Elementen nach Bedarf gereinigt werden können.

Vorteilhafte Ausführungsformen der Erfindung sind in den Zeichnungen dargestellt und werden nachfolgend beschrieben. Hierbei zeigen:
- Fig. 1: eine schematische Seitenansicht einer Reinigungskammer zur Oberflächendekontamination von darin zu platzierenden optischen Elementen,
- Fig. 2: ein Diagramm der Gesamttransmission in Abhängigkeit von der Wellenlänge für in der Vorrichtung gemäß Fig. 1 mit verschiedenen Sauerstoffpartialdrücken der Reinigungsatmosphäre gereinigte optische Elemente und
- Fig. 3: ein Vergleichsdiagramm der Transmission in Abhängigkeit von der Dekontaminationszeit für ein mit der Vorrichtung von Fig. 1 dekontaminiertes optisches Element im Vergleich zu einem mit 157nm Laserstrahlung dekontaminierten optischen Element.

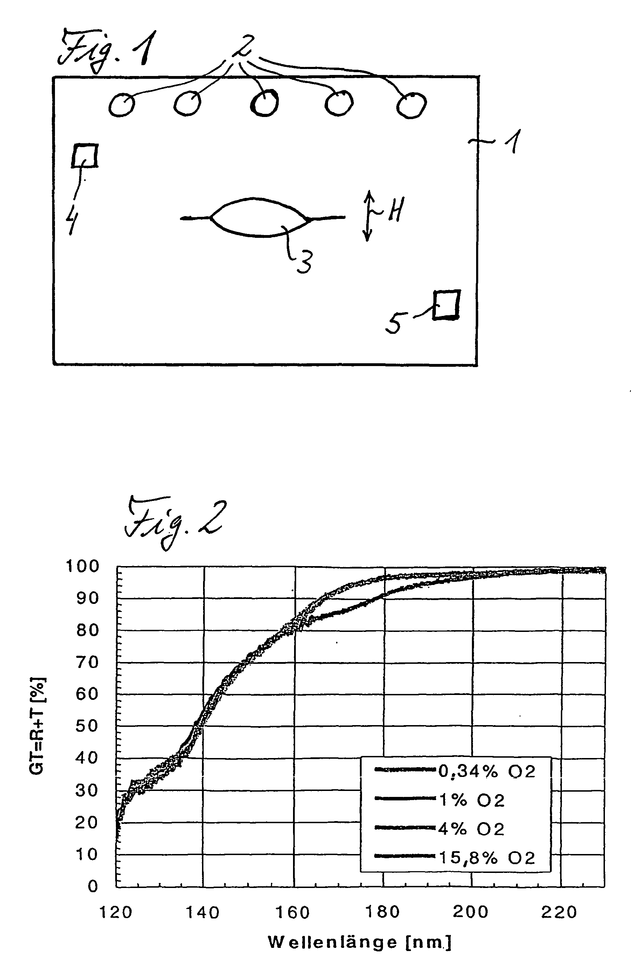

Fig. 1 zeigt den erfindungswesentlichen Teil einer Vorrichtung zur Dekontamination von Oberflächen optischer Elemente. Wie in der Schemazeichnung von Fig. 1 illustriert, beinhaltet die Dekontaminationsvorrichtung eine gasdichte Reinigungskammer 1, in der mehrere UV-Strahler 2 mit Abstand voneinander auf einer oberen Seite der Kammer 1 so angeordnet sind, dass sie UV-Strahlung zu einem Kammermittenbereich abstrahlen, der als Reinigungsbereich fungiert. In den Reinigungsbereich können optische Elemente zwecks Dekontamination bzw. Reinigung ihrer Oberflächen eingebracht werden, als Beispiel in Fig. 1 eine Linse 3 mit zugehöriger Fassung. Über den Reinigungsbereich in der Kammer 1 kann ein Reinigungsgasstrom hinweggeführt werden, wozu die Kammer 1 mit einem Gaseinlass 4 in einem ersten Kammerseitenbereich und mit einem Gasauslass 5 in einem gegenüberliegenden, zweiten Kammerseitenbereich versehen ist. Das zugehörige Gaszufuhr- und Gasabführsystem ist herkömmlicher Art und daher in Fig. 1 nicht explizit gezeigt.

Als UV-Strahler 2 dienen Xenon-Entladungslampen, die eine Excimerstrahlung als Kontinuum mit einer Bandbreite von ca. 13nm um eine zentrale Wellenlänge von 172nm abstrahlen. Durch die beabstandete Anordnung der mehreren UV-Strahler 2 gelangt die Dekontaminationsstrahlung unter verschiedenen Winkeln und mit über den Reinigungsbereich hinweg recht gleichmäßiger Intensität in den Reinigungsbereich, so dass die den UV-Strahlern 2 zugewandte Oberfläche des jeweils zu reinigenden optischen Elementes 3 großflächig und gleichmäßig von der Dekontaminationsstrahlung beaufschlagt werden kann. Dadurch lassen sich sowohl im wesentlichen plane als auch stark nicht-plane Oberflächen zuverlässig reinigen. Zur Erhöhung der Intensität können auf der Rückseite geeignete Reflektoren angebracht werden. Es versteht sich, dass je nach Anwendungsfall die UV-Strahler 2 statt wie gezeigt auf einer Seite der Kammer 1 alternativ in einer anderen Weise verteilt an geeigneten Stellen der Reinigungskammer 1 angeordnet sein können.

Bevorzugt ist im Reinigungsbereich ein nicht gezeigter Träger vorgesehen, an dem das jeweils zu reinigende optische Element 3 montiert wird und der höhenbeweglich in der Kammer 1 gehalten ist, wie in Fig. 1 symbolisch durch einen Höhenverstellungspfeil H angedeutet. Bei Bedarf kann eine zusätzliche Beweglichkeit des Trägers vorgesehen sein, z.B. derart, dass das zu reinigende optische Element 3 im Reinigungsbereich der Kammer 1 gedreht werden kann.

Die für die UV-Strahler 2 gewählte Strahlungswellenlänge von 172nm erweist sich als besonders effizient zur Ozonproduktion, da sie nahe beim Absorptionsmaximum von molekularem Sauerstoff (O₂) liegt. Die hierzu verwendeten Xe-Entladungslampen weisen eine hohe UV-Strahlungseffizienz auf, was die thermische Belastung des zu reinigenden optischen Elements 3 niedrig hält. Geeignete Xe-Excimerstrahler sind in verschiedenen Bauformen kommerziell erhältlich, z.B. von der Firma Radium in Wipperfürth. Alternativ ist die Verwendung von Quecksilber-Niederdrucklampen mit Emissionslinien im Bereich von 185nm und 254nm möglich, deren spektrale Intensität im sehr tiefen (VUV-) Wellenlängenbereich aber niedriger als diejenige von Xe-Entladungslampen ist.

Für die von den Xe-Entladungslampen 2 emittierte UV-Strahlung mit einer Wellenlänge um 172nm liegt der Sauerstoffabsorptionskoeffizient in der Größenordnung von 5 cm⁻¹, was einer Halbwertsreichweite von 1,4mm in reinem Sauerstoff und ca. 7mm in Luft entspricht. Für die Reinigungsatmosphäre werden abhängig vom Anwendungsfall beliebige Konzentrationswerte zwischen 0% und der Luftsauerstoffkonzentration gewählt, bevorzugt von höchstens etwa 1 % und noch bevorzugter von höchstens 0,1%. Letzteres hat eine Halbwertsreichweite von 10cm und mehr zur Folge, wodurch auch stark gekrümmte Oberflächen und/oder Oberflächen von kleinen Baugruppen problemlos in ausreichendem Maß von der Dekontaminationsstrahlung beaufschlagt und dadurch ausreichend gereinigt werden können. Es hat sich gezeigt, dass selbst deutlich kontaminierte Oberflächen bei einer Sauerstoffkonzentration von ca. 0,1 % effektiv gereinigt werden. Als Reinigungsgasstrom wird hierbei ein möglichst sauberes Inertgas, wie Stickstoff, über den Reinigungsbereich hinweggeführt, dem Sauerstoff in der gewünschten, niedrigen Konzentration beigemengt ist.

Die zu beseitigenden Verunreinigungen, welche beispielsweise in Lithographieoptiken stören, die im VUV-Bereich arbeiten, sind vor allem Kohlenwasserstoffe (CₓH_{y}) und Wasser (H₂O). Es zeigt sich, dass bei geringer Verunreinigung durch Kohlenwasserstoffe auf eine Sauerstoffbeimengung im Inertgas-Reinigungsgasstrom häufig ganz verzichtet werden kann, wobei der Restsauerstoffgehalt im Inertgasstrom dann typischerweise nur noch wenige ppm bis herunter zu nahezu sauerstofffreien Atmosphären mit O₂-Konzentrationen unter 0,1ppm beträgt. Die Reichweite der 172nm Dekontaminationsstrahlung ist dann nicht mehr durch Absorption limitiert und ergibt sich ausschließlich aus der geometrischen Anordnung der UV-Strahler 2.

Zur Beibehaltung einer sauberen Reinigungsatmosphäre bestehen die Wände der Reinigungskammer 1 bevorzugt aus einem gegen VUV-Bestrahlung beständigen Material, wie entfettetem und elektropoliertem Edelstahl. Für den Reinigungsgasstrom sind z.B. Gasflüsse zwischen 5slm und 50slm geeignet. Der Reinigungsgaseinlass 4 kann als Gasdusche ausgelegt sein, mit der das Reinigungsgas gezielt an die zu reinigenden Oberflächen geführt werden kann.

Die Reinigungswirkung bei sehr geringen Sauerstoffkonzentrationen ist dem Aktivieren oder Aufbrechen von Bindungen der Kohlenwasserstoffmoleküle durch die UV-Strahlung zuzuschreiben, die dann zum Teil als CₓH_{y}-Moleküle desorbieren, zum Teil vom Ozon, das aus eventuell vorhandenem Restsauerstoff gebildet wird, zu CO₂ und H₂O oxidiert werden und dann desorbieren. Es hat sich gezeigt, dass mit dieser Dekontaminationstechnik, die ein UV-Strahlerfeld 2 für großflächige Oberflächenbestrahlung mit einer sauerstoffarmen bzw. sauerstofffreien Reinigungsatmosphäre kombiniert, optische Elemente und aus diesen aufgebaute Baugruppen in ausreichender Weise effektiv und ökonomisch dekontaminiert werden können. Im Vergleich zu einer Reinigung mit 157nm Laserstrahlung ist der vorliegend verwendete Dekontaminationsprozess deutlich weniger aufwendig und erlaubt eine signifikant großflächigere Reinigung, die nicht auf wenige mm² begrenzt ist.

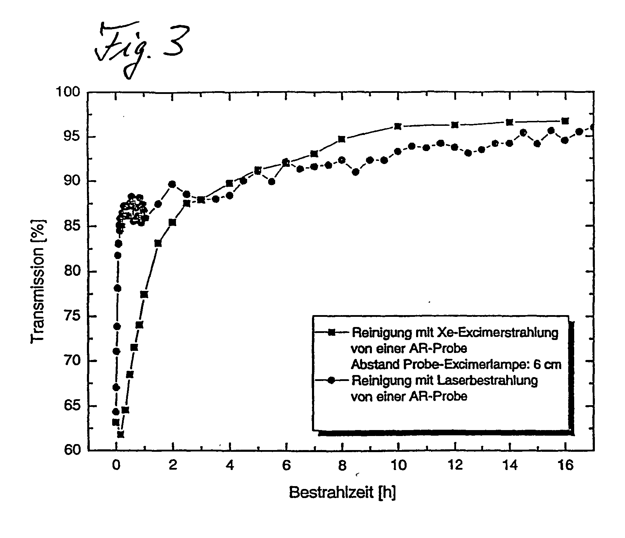

Die Diagramme der Fig. 2 und 3 bestätigen die obigen Aussagen über die erfindungsgemäß erzielbare Reinigungswirkung anhand konkreter, graphisch dargestellter Reinigungsergebnisse. Speziell veranschaulicht Fig. 2 die Ergebnisse einer Versuchsreihe, bei der gleichartige, mit einer Antireflexbeschichtung versehene Oberflächen optischer Elemente mit 172nm Xe-Excimerstrahlung, wie oben beschrieben, unter Verwendung einer Reinigungsatmosphäre mit unterschiedlichen Sauerstoffpartialdrücken gereinigt wurden. Anschließend wurde die Gesamttransmission GT, d.h. die Summe aus Reflexionsanteil R und Transmissionsanteil T, für auf die gereinigten optischen Elemente gerichtete Strahlung in Abhängigkeit von der Wellenlänge für einen Wellenlängenbereich zwischen 120nm und 230nm bestimmt. Dabei wurden Reinigungsatmosphären mit vier unterschiedlichen Sauerstoffkonzentrationen zwischen 0,34% und 15,8% verwendet. Wie aus Fig. 2 ersichtlich, ergibt sich in allen vier Fällen eine ähnlich gute Reinigungswirkung, die zu einem gesamten Transmissionsvermögen GT für 157nm Laserstrahlung von ca. 80% führt und für größere Wellenlängen noch weiter bis nahe 100% ansteigt.

Fig. 3 zeigt einen Vergleich der erfindungsgemäßen Vorgehensweise mit der aufwendigeren und nur kleinflächiger realisierbaren 157nm Laserstrahlungsreinigung. Die Versuchsreihe von Fig. 3 basiert auf einem erfindungsgemäßen Reinigungsprozess unter Benutzung einer 172nm Xe-Excimerstrahlung einerseits und einem Reinigungsprozess mit 157nm Laserstrahlung einer Energiedichte von 2 mJ/cm² andererseits, jeweils einer mit einer Antireflexbeschichtung versehenen Oberfläche eines optischen Elements. Konkret zeigt Fig. 3 die Reinigungswirkung anhand des sich nach dem Reinigungsprozess ergebenden Transmissionsgrades des optischen Elements aufgetragen in Abhängigkeit von der Bestrahlzeit im Reinigungsprozess. Wie sich aus Fig. 3 ergibt, führt der erfindungsgemäße Reinigungsprozess mit der weniger aufwendigen Xe-Excimerstrahlung von 172nm zu einer vergleichbar guten Reinigungswirkung wie die aufwendige 157nm Laserbestrahlung, wobei für längere Bestrahlungsdauern sogar noch ein höherer Transmissionsgrad für den erfindungsgemäßen Dekontaminationsprozess festzustellen ist.

Während im Ausführungsbeispiel von Fig. 1 die Dekontaminationsvorrichtung zur Reinigung einzelner optischer Elemente oder Baugruppen in der Reinigungskammer 1 vor deren eigentlichem Einsatz zur Strahlführung in einer entsprechenden Optik dient, ist in alternativen Realisierungen der Erfindung vorgesehen, eine strahlführende Optik auch nach deren Montage und Inbetriebnahme in erfindungsgemäßer Weise dekontaminieren zu können. Dazu bildet die Dekontaminationsvorrichtung dann einen integralen Teil der Einrichtung, welche die strahlführende Optik beinhaltet. Beispielsweise kann die Dekontaminationsvorrichtung Teil einer Mikrolithographie-Projektionsbelichtungsanlage sein, indem zusätzlich zu deren strahlführender Optik eine oder mehrere UV-Dekontaminationsstrahlungsquellen an geeigneter Stelle platziert werden und ein Reinigungsgas-Spülsystem implementiert wird, wie für andere Dekontaminationsvorrichtungen z.B. im eingangs erwähnten Stand der Technik beschrieben, so dass dies hier keiner näheren Darstellung und Erläuterung bedarf. In diesem Fall können die Linsen und andere optische Elemente der Projektionsbelichtungs-Baugruppe nicht nur im Produktionsprozess vor, während und nach einem Beschichtungsprozess, sondern auch noch während und nach der Montage und Justierung der Optik nach Inbetriebnahme der Belichtungsanlage von Zeit zu Zeit dem Oberflächendekontaminationsprozess unter Einsatz z.B. von 172nm Xe-Excimerstrahlung in Kombination mit einem sauerstoffarmen bis sauerstofffreien Reinigungsgasstrom unterzogen werden.

## Patentansprüche

1. Verfahren zur Dekontamination von Oberflächen strahlführender Optiken, insbesondere von Oberflächen optischer Elemente von Mikrolithographie-Projektionsbelichtungsanlagen, bei dem
- die zu reinigende Oberfläche mit UV-Strahlung in einer Reinigungsatmosphäre beaufschlagt wird,
**dadurch gekennzeichnet, dass**
- als UV-Reinigungsstrahlung eine solche gewählt wird, deren Wellenlänge in einem Bereich starker Sauerstoffabsorption liegt und als Reinigungsatmosphäre eine solche gewählt wird, deren Sauerstoffkonzentration kleiner als diejenige von Luft ist.

2. Verfahren nach Anspruch 1, weiter **dadurch gekennzeichnet, dass** die Sauerstoffkonzentration der Reinigungsatmosphäre unter 1%, bevorzugt unter 0, 1 %, liegt.

3. Verfahren nach Anspruch 1 oder 2, weiter **dadurch gekennzeichnet, dass** als UV-Reinigungsstrahlung Excimer-Strahlung einer Xe-Entladungslampe im Wellenlängenbereich um 172nm oder die Strahlung einer Hg-Niederdrucklampe verwendet wird.

4. Vorrichtung zur Dekontamination von Oberflächen strahlführender Optiken, insbesondere von Oberflächen optischer Elemente von Mikrolithographie-Projektionsbelichtungsanlagen, mit
- einer oder mehreren UV-Strahlungsquellen (2) zur Erzeugung einer UV-Reinigungsstrahlung und
- Mitteln (4, 5) zur Bereitstellung einer vorgebbaren Reinigungsatmosphäre,
**dadurch gekennzeichnet, dass**
- die Wellenlänge der UV-Reinigungsstrahlung in einem Bereich starker Sauerstoffabsorption liegt und die Mittel zur Bereitstellung der Reinigungsatmosphäre darauf ausgelegt sind, eine Reinigungsatmosphäre mit einer Sauerstoffkonzentration kleiner als diejenige von Luft bereitzustellen.

5. Vorrichtung nach Anspruch 4, weiter **dadurch gekennzeichnet, dass** die Mittel zur Bereitstellung der Reinigungsatmosphäre darauf ausgelegt sind, eine Reinigungsatmosphäre mit einer Sauerstoffkonzentration kleiner 1 %, bevorzugt kleiner 0,1 %, bereitzustellen.

6. Vorrichtung nach Anspruch 4 oder 5, weiter **dadurch gekennzeichnet, dass** die jeweilige UV-Strahlungsquelle eine Xe-Entladungslampe mit Emissionswellenlänge um 172nm oder eine Quecksilber-Niederdrucklampe beinhaltet.

7. Vorrichtung nach einem der Ansprüche 4 bis 6, weiter **dadurch gekennzeichnet, dass** sie eine Reinigungskammer (1) mit einem Reinigungsbereich, in welchem ein jeweils zu reinigendes Objekt platzierbar ist, und mehrere im Abstand in der Reinigungskammer angeordnete, auf den Reinigungsbereich wirkende UV-Strahlungsquellen (2) beinhaltet und die Mittel zur Bereitstellung der Reinigungsatmosphäre Mittel zur Führung eines Reinigungsgasstroms über den Reinigungsbereich hinweg beinhalten.

8. Vorrichtung nach einem der Ansprüche 4 bis 6, weiter **dadurch gekennzeichnet, dass** sie in eine optische Baugruppe integriert ist.

9. Vorrichtung nach Anspruch 8, weiter **dadurch gekennzeichnet, dass** die optische Baugruppe Teil einer Mikrolithographie-Projektionsbelichtungsanlage ist.

## Claims

1. Method for the decontamination of surfaces of beam-guiding optics, in particular of surfaces of optical elements of microlithography projection exposure apparatuses, wherein
- UV radiation is applied to the surface to be cleaned in a cleaning atmosphere,
**characterized in that**
- the UV cleaning radiation chosen is one whose wavelength lies in a range of high oxygen absorption, and the cleaning atmosphere chosen is one whose oxygen concentration is less than that of air.

2. Method according to Claim 1, further **characterized in that** the oxygen concentration of the cleaning atmosphere is less than 1%, preferably less than 0.1%.

3. Method according to Claim 1 or 2, further **characterized in that** excimer radiation from an Xe discharge lamp in the wavelength range around 172 nm or the radiation from a low-pressure Hg lamp is used as the UV cleaning radiation.

4. Device for the decontamination of surfaces of beam-guiding optics, in particular of surfaces of optical elements of microlithography projection exposure apparatuses, comprising
- one or more UV radiation sources (2) for generating a UV cleaning radiation, and
- means (4, 5) for providing a predeterminable cleaning atmosphere,
**characterized in that**
- the wavelength of the UV cleaning radiation lies in a range of high oxygen absorption and the means for providing the cleaning atmosphere are designed to provide a cleaning atmosphere having an oxygen concentration less than that of air.

5. Device according to Claim 4, further **characterized in that** the means for providing the cleaning atmosphere are designed to provide a cleaning atmosphere having an oxygen concentration of less than 1%, preferably less than 0.1%.

6. Device according to Claim 4 or 5, further **characterized in that** the respective UV radiation source comprises an Xe discharge lamp with an emission wavelength around 172 nm or a low-pressure mercury lamp.

7. Device according to one of Claims 4 to 6, further **characterized in that** it comprises a cleaning chamber (1) with a cleaning region, in which an object that is respectively to be cleaned can be positioned, and a plurality of UV radiation sources (2) that are arranged at a distance in the cleaning chamber and act on the cleaning region, and the means for providing the cleaning atmosphere comprise means for guiding a cleaning gas stream across the cleaning region.

8. Device according to one of Claims 4 to 6, further **characterized in that** it is integrated into an optical assembly.

9. Device according to Claim 8, further **characterized in that** the optical assembly is part of a microlithography projection exposure apparatus.

## Revendications

1. Procédé de décontamination de surfaces d'optiques conductrices de rayons, notamment de surfaces d'éléments optiques d'installations d'exposition à projection de microlithographies, dans lequel
- la surface à nettoyer est sollicitée au rayonnement UV dans une atmosphère nettoyante,
**caractérisé en ce que**
- on choisit comme rayonnement UV nettoyant un rayon dont la longueur d'onde se situe dans une plage de forte absorption d'oxygène et comme atmosphère nettoyante une atmosphère dont la concentration en oxygène est inférieure à celle de l'air.

2. Procédé selon la revendication 1, **caractérisé en outre en ce que** la concentration en oxygène de l'atmosphère nettoyante se situe en dessous de 1 %, de préférence en dessous de 0,1 %.

3. Procédé selon la revendication 1 ou 2, **caractérisé en outre en ce qu'**on utilise comme rayonnement UV nettoyant le rayonnement excimère d'une lampe à décharge de Xe dans la plage de longueur d'onde aux alentours de 172 nm ou le rayonnement d'une lampe à basse pression à Hg.

4. Dispositif de décontamination de surfaces d'optiques conductrices de rayons, notamment de surfaces d'éléments optiques d'installations d'exposition à projection de microlithographies, comportant
- une ou plusieurs sources de rayonnement UV (2) pour générer un rayonnement UV nettoyant et
- des moyens (4, 5) d'établissement d'une atmosphère nettoyante prescriptible,
**caractérisé en ce que**
- la longueur d'onde du rayonnement UV nettoyant se situe dans une plage de forte absorption d'oxygène et que les moyens d'établissement de l'atmosphère nettoyante sont conçus de manière à établir une atmosphère nettoyante ayant une concentration en oxygène inférieure à celle de l'air.

5. Dispositif selon la revendication 4, **caractérisé en outre en ce que** les moyens d'établissement de l'atmosphère nettoyante sont conçus pour établir une atmosphère nettoyante ayant une concentration en oxygène inférieure à 1 %, de préférence inférieure à 0,1 %.

6. Dispositif selon la revendication 4 ou 5, **caractérisé en outre en ce que** la source respective de rayonnement UV comprend une lampe à décharge de Xe ayant une longueur d'onde d'émission aux alentours de 172 nm ou une lampe à basse pression au mercure.

7. Dispositif selon l'une quelconque des revendications 4 à 6, **caractérisé en outre en ce qu'**il comprend une chambre de nettoyage (1) comportant une zone de nettoyage dans laquelle on peut placer l'objet à nettoyer et plusieurs sources de rayonnement UV (2) disposées à distance de la chambre de nettoyage et agissant sur la zone de nettoyage et que les moyens d'établissement de l'atmosphère nettoyante comprennent des moyens de guidage d'un courant de gaz nettoyant dans la zone de nettoyage.

8. Dispositif selon l'une quelconque des revendications 4 à 6, **caractérisé en outre en ce qu'**il est intégré dans un agrégat optique.

9. Dispositif selon la revendication 8, **caractérisé en outre en ce que** l'agrégat optique fait partie intégrante d'une installation d'exposition à projection de microlithographies.
